# EUROPEAN PATENT APPLICATION

(11) **EP 4 480 903 A2**
(43) Date of publication of application: **25.12.2024**
(21) Application number: 24182532.2
(22) Date of filing: 17.06.2024
(51) Int. Cl.: B82Y 10/00, H01L 21/8234, H01L 29/06, H01L 29/10, H01L 29/417, H01L 29/66, H01L 29/775

(54) **SEMICONDUCTOR DEVICE INCLUDING SELF-ALIGNED BACKSIDE CONTACT STRUCTURE**

(30) Priority: 22.06.2023 US 202363522522 P; 29.09.2023 US 202318375186
(71) Applicant: Samsung Electronics Co., Ltd., Suwon-si, Gyeonggi-do 16677 (KR)
(72) Inventor: KIM, Tae Sun, San Jose, CA, 95134 (US); LEE, Jongjin, San Jose, CA, 95134 (US); MARTINEAU, Jason, San Jose, CA, 95134 (US); SEO, Kang-ill, San Jose, CA, 95134 (US); HONG, Wonhyuk, San Jose, CA, 95134 (US)
(74) Representative: Kuhnen & Wacker Patent- und Rechtsanwaltsbüro PartG mbB

(57) **Abstract**

Provided is a semiconductor device 10 and a method of manufacturing the semiconductor device 10. The semiconductor device 10 includes: a 1^{st} source/drain region 130L; a 2^{nd} source/drain region 130R; a channel structure 110 connecting the 1^{st} source/drain region 130L to the 2^{nd} source/drain region 130R; a gate structure 115 surrounding the channel structure 110; a backside contact structure 150, below the 1^{st} source/drain region 130L, connected to the 1^{st} source/drain region 130L; and a 1^{st} backside spacer 151 at a lateral side of the backside contact structure 150, and/or an isolation stack 100, below the gate structure 115, comprising at least one isolation layer 103 and a substrate layer 105 which are vertically stacked.

## Description

### BACKGROUND

### 1. Field

Apparatuses and methods related to the disclosure relate to a semiconductor device in which a backside contact structure is formed in a self-aligned manner.

### 2. Description of the Related Art

A backside power distribution network (BSPDN) for a semiconductor device has been introduced to address a heavy traffic of signal lines at a front side of the semiconductor device. The BSPDN includes connection structures formed at a back side of a semiconductor device. Here, the front side refers to a side where a transistor is formed with respect to a top surface of a substrate, and the back side refers to a side opposite to the front side.

The BSPDN formed on a back side of a 3D-stacked semiconductor device may include backside metal lines, such as a buried power rail, and backside contact structures. A backside contact structure may be formed on a bottom surface of a lower source/drain region (epitaxial structure) of a field-effect transistor such as a nanosheet transistor or a fin field-effect transistor (FinFET), and the backside metal line may connect the backside contact structure to a voltage source or another circuit element for signal routing.

The FinFET has one or more fin structures as a channel structure of the transistor. The fin structures vertically protrude from a substrate and horizontally extend, and at least three surfaces thereof are surrounded by a gate structure. The nanosheet transistor is characterized by one or more nanosheet channel layers as a channel structure of the transistor. The nanosheet channel layers vertically stacked based on a substrate and horizontally extend, and all four surfaces of each of the nanosheet channel layers are surrounded by a gate structure. The nanosheet transistor is referred to as gate-all-around (GAA) transistor, or as a multi-bridge channel field-effect transistor (MBCFET).

As the contact poly pitch (CPP) of a semiconductor device including a plurality of field-effect transistors is reduced to increase device density, it becomes more difficult and complicated to form a backside contact structure in a back side of the semiconductor device. For example, the backside contact structure may not be precisely aligned with and connected to a bottom surface of a source/drain region of the semiconductor device in a nanometer-scale dimension at least because of substrate warpage occurring in thermal processing of the device, etching variation, etc. Further, when a substrate of a semiconductor device is etched to form a hole or recess in which the backside contact structure is to be formed, the hole or recess may have a tapering or cone shape which may make deposition of a metal from a back side of the semiconductor device during a backside process.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

The disclosure provides a semiconductor device in which a lower source/drain region for a lower transistor below an upper transistor is formed in a backside process forming a backside contact structure. The disclosure also provides a method of manufacturing this semiconductor device.

According to an embodiment, there is provided a semiconductor device which may include: a 1^{st} source/drain region; a 2^{nd} source/drain region; a channel structure connecting the 1^{st} source/drain region to the 2^{nd} source/drain region; a gate structure surrounding the channel structure; a backside contact structure, below the 1^{st} source/drain region, connected to the 1^{st} source/drain region; and a 1^{st} backside spacer at a lateral side of the backside contact structure.

According to an embodiment, the semiconductor device may further include an isolation stack, below the gate structure, including at least one isolation layer and a substrate layer which are vertically stacked; and a backside isolation structure below the isolation stack.

According to an embodiment, the at least one isolation layer may include a plurality of vertcially stacked isolation layers, and the substrate layer may be disposed between two adjacent isolation layers among the isolation layers

According to an embodiment, the semiconductor device may further include: a 1^{st} source/drain region; a 2^{nd} source/drain region; a channel structure connecting the 1^{st} source/drain region to the 2^{nd} source/drain region; a gate structure surrounding the channel structure; a backside contact structure, below the 1^{st} source/drain region, connected to the 1^{st} source/drain region; and an isolation stack, below the gate structure, comprising a plurality of isolation layers and a substrate layer disposed between two adjacent isolation layers among the isolation layers.

According to an embodiment, the semiconductor device may further include: a 1^{st} backside spacer at a lateral side of the backside contact structure; a placeholder structure, below the 2^{nd} source/drain region, connected to the 2^{nd} source/drain region; and a 2^{nd} backside spacer at a lateral side of the placeholder structure.

According to embodiments, there is provided a method of manufacturing a semiconductor device. The method may include: formig a isolation stack including a plurality of isolation layers and a substrate layer between a substrate and a channel stack; etching the isolation stack to form a recess; forming a backside spacer at a side surface of the recess; forming a placeholder structure in the recess based on the backside spacer; forming a source/drain region on the placeholder structure based on the channel stack; and replacing the placeholder structure with a backside contact structure based on the backside spacer.

### BRIEF DESCRIPTION OF DRAWINGS

Example embodiments of the disclosure will be more clearly understood from the following detailed description taken in conjunction with the accompanying drawings in which:
FIG. 1A illustrates a top plan view of a semiconductor device including a self-aligned backside contact structure, according to an embodiment;
FIG. 1B illustrates a cross-section view of the semiconductor device of FIG. 1A along a line I-I' shown therein in a D1 direction, according to an embodiment;
FIGS. 2A-2P illustrate intermediate semiconductor devices obtained after respective steps of manufacturing a semiconductor device including a self-aligned contact structure, according to embodiments;
FIG. 3 illustrates a flowchart describing a method of manufacturing a semiconductor device including a self-aligned contact structure in reference to FIGS. 2A-2P, according to embodiments; and
FIG. 4 is a schematic block diagram illustrating an electronic device including one or more semiconductor devices including a self-aligned backside contact structure as shown in FIGS. 1A and 1B, according to embodiments.

### DETAILED DESCRIPTION OF EXAMPLE EMBODIMENTS

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" or "equal" is used to compare a dimension of two or more elements, the term may cover a "substantially same" or "substantially equal" dimension. Further, when a term "coplanar" or "aligned" is used to compare a positional relationship between two or more elements, the term may also cover "a substantially coplanar" or "substantially alighted" dimension.

It will be also understood that, even if a certain step or operation of manufacturing an apparatus or structure is described later than another step or operation, the step or operation may be performed faster than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity. Thus, it is to be understood that such schematic illustrations may not reflect actual images when any of the structures described herein are examined through scanning electron microscopy (SEM), transmission electron microscopy (TEM), focused ion beam (FIB) microscopy, etc.

For the sake of brevity, conventional elements, structures or layers of semiconductor devices including a nanosheet transistor, a fin field-effect transistor, and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments.

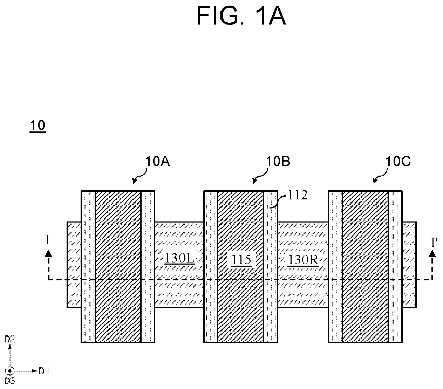

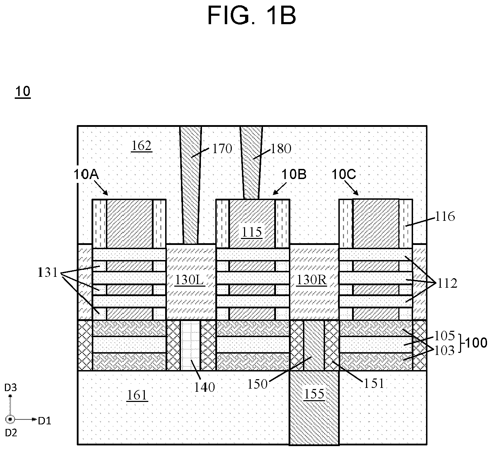

FIG. 1A illustrates a top plan view of a semiconductor device including a self-aligned backside contact structure, according to an embodiment. FIG. 1B illustrates a cross-section view of the semiconductor device of FIG. 1A along a line I-I' shown therein in a D1 direction, according to an embodiment.

It is to be understood here that the D1 direction is a channel-length direction which intersects a D2 direction, which is a channel-width direction, and a D3 direction which is a vertical direction.

Referring to FIG. 1A and 1B, a semiconductor device 10 may include 1^{st} to 3^{rd} semiconductor stacks 10A-10C each of which may include a plurality of channel layers 112 vertically stacked on a front side of the semiconductor device 10 and surrounded by a gate structure 115. Each of the channel layers 112 may be referred to as a nanosheet or nanoribbon. Each of the semiconductor stacks 10A-10C may also include an isolation stack 100 including a couple of isolation layers 103 and a substrate layer 105 therebetween. A backside isolation structure 161 may be formed below the semiconductor stacks 10A-10C.

The channel layers 112 of each of the semiconductor stacks 10A-10C surrounded by the gate structure 115 may form a channel structure which connects source/drain regions formed at both sides of the channel structure to each other to form a field-effect nanosheet transistor. For example, a field-effect nanosheet transistor may be formed by a channel structure including the channel layers 112, the gate structure 115 surrounding the channel structure, and 1^{st} and 2^{nd} source/drain regions 130L and 130R connected to each other by the channel structure.

One or more materials forming the channel layers 112 may include, for example, silicon (Si), silicon germanium (SiGe). The gate structure 115 may be formed of one or more materials including, for example, copper (Cu), aluminum (Al), cobalt (Co), tungsten (W), titanium (Ti), tantalum (Ta) or their combination. Each of the source/drain regions 130L and 130R may include one or more materials, for example, silicon (Si), silicon germanium (SiGe) doped with impurities. The source/drain regions 130L and 130R may be either a p-type or an n-type.

Each of the semiconductor stacks 10A-10C may also include inner spacers 131 formed at side surfaces of lower portions of the gate structure 115 and gate spacers 116 formed at side surfaces of an upper portion of the gate structure 115. The inner spacers 131 may isolate the gate structure 115 from the source/drain regions 130L and 130R, and the gate spacers 116 may isolate the gate structure 115 from the source/drain regions 130L and 130R and other frontside isolation structure 162. One or more materials forming the inner spacers 131 and the gate spacers 116 may include, for example, silicon oxide (e.g., SiO₂) or silicon nitride (Si₃N₄). The frontside isolation structure 162 may be formed of, for example, silicon oxide (e.g., SiO or SiO₂).

The semiconductor device 10 may also include a plurality of contact structures including a frontside contact structure 170, a gate contact structure 180, and a backside contact structure 150. The frontside contact structure 170 may be formed on a top surface of the 1^{st} source/drain region 130L to connect this source/drain region to a voltage source or another semiconductor device. The gate contact structure 180 may be formed on a top surface of the gate structure 115 to receive a gate input signal for the gate structure 115. The frontside contact structure 170 and the gate contact structure 180 may be isolated from each other though the frontside isolation structure 162. The backside contact structure 150 may be formed on a bottom surface of the 2^{nd} source/drain region 130R to connect this source/drain region to a voltage source or another semiconductor device. These contact structures 170, 180 and 150 may each be formed of one or more materials such as copper (Cu), aluminum (Al), tungsten (W), ruthenium (Ru), molybdenum (Mo), etc.

The semiconductor device 10 may be characterized by the isolation stack 100 formed at the lower portion of each of the semiconductor stacks 10A-10C. The isolation stack 100 may include the two isolation layers 103 and the substrate layer 105 disposed therebetween.

The uppermost isolation layer among the isolation layers 103 may be formed below the lowermost portion of the gate structure 115 and the lowermost inner spacers among the inner spacers 131. The uppermost isolation layer 103 may suppress current leakage from the gate structure 115 thereabove. The isolation layers 103 with the substrate layer 105 therebetween may also structurally support each of the semiconductor stacks 10A-10C. The substrate layer 105 may be formed of silicon (Si), not being limited thereto. The isolation layer 103 may be formed a material such as silicon oxide (e.g., SiO₂), not being limited thereto.

FIG. 1B shows that the isolation stack 100 includes two vertically-stacked isolation layers 103 and the substrate layer 105 disposed therebetween. As the substrate layer 105 is disposed between two isolation layers 103, the isolation stack 100 may be structurally strengthened to more stably support each of the semiconductor stacks 10A-10C. Moreover, the number of the isolation layers 103 and the substrate layer 105 may be controlled such that an entire thickness of the isolation stack 100 corresponds to or is the same as a thickness of the backside contact structure 150 in the D3 direction. For example, the isolation stack 100 may include more than two isolation layers and more than one substrate layer disposed between every two vertically adjacent isolation layers. As another example, the isolation stack 100 may include only one isolation layer and only one substrate layer having a thickness corresponding to that of the two isolation layers 103 with the substrate layer 105. Still, however, the isolation layer 103 may be formed as a top layer of the isolation stack 100 to prevent current leakage from the gate structure 115 thereabove.

The semiconductor device 10 may be further characterized by a backside spacer 151 formed at lateral sides of the isolation stack 100. As the isolation stack 100 comprises the two isolation layers 103 and the substrate layer 105 which are vertically stacked on the backside isolation structure 161, the backside spacer 151 may contact side surfaces of the isolation layers 103 and the substrate layer 105. Further, the backside spacer 151 may be formed such that a top surface thereof is horizontally aligned with or coplanar with a top surface of the backside contact structure 150, a top surface of the uppermost isolation layer 103, and bottom surfaces of the lowermost inner spacer 131 and the gate structure 115.

The backside spacer 151 may have been used to form the backside contact structure 150 in a self-aligning manner when the semiconductor device 10 was manufactured, which will be further described later. The backside contact structure 150 may be formed between the backside spacers 151 formed at side surfaces of two adjacent isolation stacks 100, and connected to a backside metal line 155 formed therebelow in a backside isolation structure 161. As the backside contact structure 150 is self-aligned precisely below each of the source/drain regions 130L and 130R due to the backside spacer 151, the semiconductor device 10 may have an improved backside contact performance.

The backside spacer 151 may be formed of one or more materials including silicon nitride (e.g., SiN, SiBCN, SiOCN, SiOC, etc.). The backside spacer 151, the inner spacers 131 and the gate spacer 116 may the same or different material compositions from each other. The backside metal line 155 may be formed of one or more materials such as copper (Cu), aluminum (Al), tungsten (W), ruthenium (Ru), molybdenum (Mo), etc., which may be the same as or different from the materials forming the contact structures 150, 170 and 180. The backside isolation structure 161 may be formed of the same material forming the frontside isolation structure 162.

In the meantime, the semiconductor device 10 may include a placeholder structure 140 formed below the 1^{st} source/drain region 130L. Like the backside contact structure 150, the placeholder structure 140 may be formed laterally between the backside spacers 151. This placeholder structure 140 may have been formed to provide a space for formation of another backside contact structure during the manufacturing process of the semiconductor device 10. Thus, the backside contact structure 150 formed below the 2^{nd} source/drain region 130R may have been formed by replacing a placeholder structure formed below the 2^{nd} source/drain region. However, the placeholder structure 140 below the 1^{st} source/drain region 130L may have remained there without being replaced by another backside contact structure because of the frontside contact structure 170 formed on the 1^{st} source/drain region 130L to connect the 1^{st} source/drain region 130L to a voltage source or another circuit element. The placeholder structure 140 may be formed of a material including silicon germanium (SiGe) or silicon oxide (e.g., SiO, SiO₂, etc.), not being limited thereto.

As the placeholder structure 140 is replaced by the backside contact structure 150, these two structures may have the same structural shape. Thus, a top surface of the placeholder structure 140 may be horizontally aligned with or coplanar with the top surface of the backside spacer 151 formed at sides of the placeholder structure 140, the top surface of the uppermost isolation layer 103, and the bottom surfaces of the lowermost inner spacer 131 and the gate structure 115.

In the present embodiments, the isolation stack 100 including the isolation layers 103 and the substrate layer 105 may have the same thickness as the placeholder structure 140 as well as the backside contact structure 150 and the backside spacer 151 in the D3 direction.

In the above embodiment, FIGS. 1A and 1B show that the semiconductor device 10 includes only three semiconductor stacks 10A-10C, one backside contact structure 150 with the backside spacers 151 at two opposite side surfaces thereof, and one placeholder structure with the backside spacers 151 at two opposite side surfaces thereof. However, the disclosure is not limited thereto. The semiconductor device 10 may include more than three semiconductor stacks to form more nanosheet field-effect transistors, and more than one backside contact structure and one placeholder structure may be formed to be connected to bottom surfaces of corresponding source/drain regions of the nanosheet field-effect transistors, according to embodiments. Further, according to embodiments, at least one of these nanosheet field-effect transistors may include only one of the backside contact structure 150 and the placeholder structure 140 which is formed on a bottom surface of a source/drain region and has the backside spacers 151 on the side surfaces thereof.

Herebelow, a method of manufacturing the semiconductor device 10 including the self-aligned backside contact structure 150 will be described.

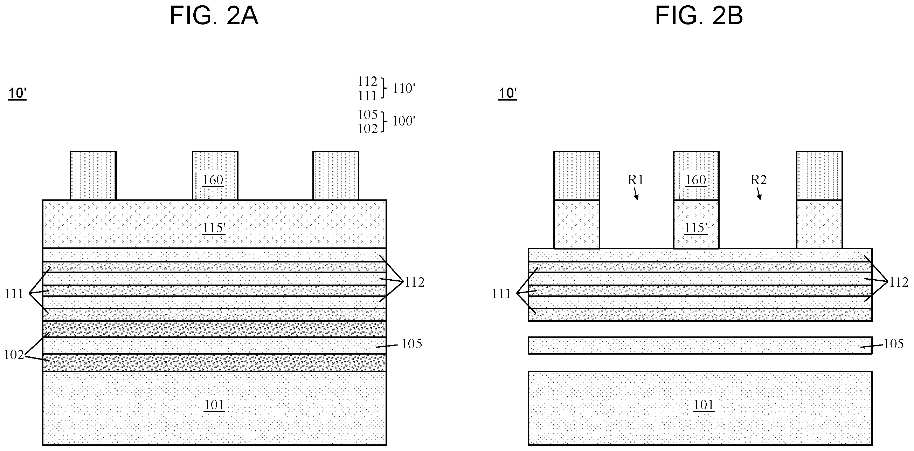

FIGS. 2A-2P illustrate intermediate semiconductor devices obtained after respective steps of manufacturing a semiconductor device including a self-aligned contact structure, according to embodiments. As the semiconductor device manufactured through the respective steps may be the same as or corresponds to the semiconductor device 10 shown in FIGS. 1A and 1B, duplicate descriptions thereof may be omitted and the same reference numbers may be used in the descriptions herebelow.

Referring to FIG. 2A, an intermediate semiconductor device 10' may include a substrate 101 on which a preliminary isolation stack 100', a preliminary channel stack 110', a dummy gate structure 115' and three hard mask patterns 160 are formed in this order.

The preliminary isolation stack 100' and the preliminary channel stack 110' may include a plurality of nanosheet layers epitaxially grown and stacked on the substrate 101 in the following order: a 1^{st} sacrificial layer 102, a substrate layer 105, a 1^{st} sacrificial layer 102, a 2^{nd} sacrificial layer 111, a channel layer 112, a 2^{nd} sacrificial layer 111, a channel layer 112, a 2^{nd} sacrificial layer 111, and a channel layer 112. However, unlike FIG. 2A, the preliminary isolation stack 100' may include more than two 1^{st} sacrificial layers 102, and the substrate layer 105 may be disposed between every two vertically adjacent 1^{st} sacrificial layers 102, according to embodiments. Further, unlike FIG. 2A, the channel preliminary stack 110' may include more or less than three 2^{nd} sacrificial layers 111 and three channel layers 112 alternatingly stacked on the uppermost 1^{st} sacrificial layer 102.

The 1^{st} sacrificial layers 102 and the 2^{nd} sacrificial layers 111 may each be formed of silicon germanium (SiGe). However, the 1^{st} sacrificial layers 102 may have a higher germanium concentration (e.g., 55%) than in the 2^{nd} sacrificial layers 111 so that the 1^{st} sacrificial layers 102 can be selectively etched against the 2^{nd} sacrificial layers 111 in a next step. The channel layers 112 may include silicon (Si) or SiGe having a germanium concentration lower than in the 2^{nd} sacrificial layers 111 so that the channel layers 112 may survive selective etching of the 2^{nd} sacrificial layers 111 in a later step when the 2^{nd} sacrificial layers 111 and the dummy gate structure 115' are replaced by a gate structure to form the intermediate semiconductor device as the semiconductor device 10 of FIGS. 1A and 1B..

The dummy gate structure 115' may be formed on the uppermost channel layer 112 and planarized through, for example, chemical mechanical polishing (CMP), not being limited thereto. The hard mask patterns 160 may be formed on the dummy gate structure 115' at positions where a gate structure for each of the 1^{st} to 3^{rd} semiconductor stacks 10A-10C shown in FIGS. 1A and 1B is to be patterned out in a later step. The dummy gate structure may be formed of a material such as polycrystalline silicon or amorphous silicon, and the hard mask patterns 160 may be formed of a material such as silicon nitride (e.g., SiN, Si₃N₄, SiBCN, SiNC, SiNOC, etc.).

Referring to FIG. 2B, the dummy gate structure 115' may be patterned to form three dummy gate structures 115' based on the hard mask patterns 160, and the 1^{st} sacrificial layers 102 may be removed from the preliminary isolation stack 100'.

The formation of the three dummy gate structures 115' may be performed through, for example, dry etching such as reactive ion etching (RIE) based on the hard mask patterns 160. The 1^{st} sacrificial layers 102 may be removed through, for example, dry etching such as reactive ion etching (RIE) or wet etching using hydrofluoric acid (HF) and/or nitric acid (HNO₃) that may selectively etch the 1^{st} sacrificial layers 102 with a high germanium concentration against the 2^{nd} sacrificial layers 111 and the channel layers 112 with a low germanium concentration.

As the dummy gate structures 115' are formed based on the hard mask patterns 160, a top surface of the preliminary channel stack 110', for example, a top surface of the uppermost channel layer 112, may be exposed through a 1^{st} recess R1 and a 2^{nd} recess R2. Further, voids or spaces may be formed by the removal of the 1^{st} sacrificial layers 102 between the substrate 101 and the substrate layer 105 and between the substrate layer 105 and the lowermost 2^{nd} sacrificial layer 111.

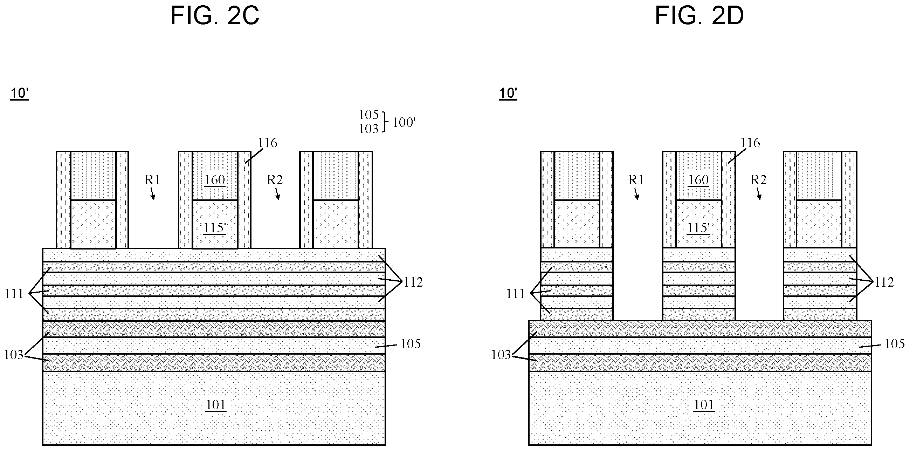

Referring to FIG. 2C, the gate spacer 116 may be formed on side surfaces of each dummy gate structure 115' with the hard mask pattern 160 thereon, and the isolation layers 103 may be formed in the voids or spaces formed by the removal of the 1^{st} sacrificial layers 102.

As the isolation layers 103 fills in the voids of spaces where the 1^{st} sacrificial layers 102 were formed, the isolation layers 103 along with the substrate layer 105 now form the preliminary isolation stack 100'.

The formation of the gate spacer 116 and the isolation layer 103 may be performed through, for example, atomic layer deposition (ALD), chemical vapor deposition (CVD), plasma enhanced CVD (PECVD), physical vapor deposition (PVD), or a combination thereof, not being limited thereto.

Although not shown in the drawings, the material such as silicon nitride forming the gate spacer 116 may be deposited on the entire intermediate semiconductor device 10' obtained in the previous step, and etched back to leave the gate spacer material only on the side surfaces of each dummy gate structure 115' with the hard mask pattern 160 thereon.

The isolation layers 103 may be formed of a material such as silicon oxide (e.g., SiO₂) or silicon nitride (e.g., Si₃N₄) to prevent or suppress current leakage from at least a gate structure to be formed thereabove in a later step.

Referring to FIG. 2D, the preliminary channel stack 110'(see FIG. 2A) may be etched down through the recesses R1 and R2 based on the hard mask patterns 160 and the gate spacers 116 to form three channel stacks 110 exposing a top surface of the preliminary isolation stack 100' therebetween.

By the etch back of the preliminary channel stack 110', the recesses R1 and R2 may be extended down to expose the top surface of the uppermost isolation layer 103. The etch back operation may be performed through, for example, dry etching, not being limited thereto.

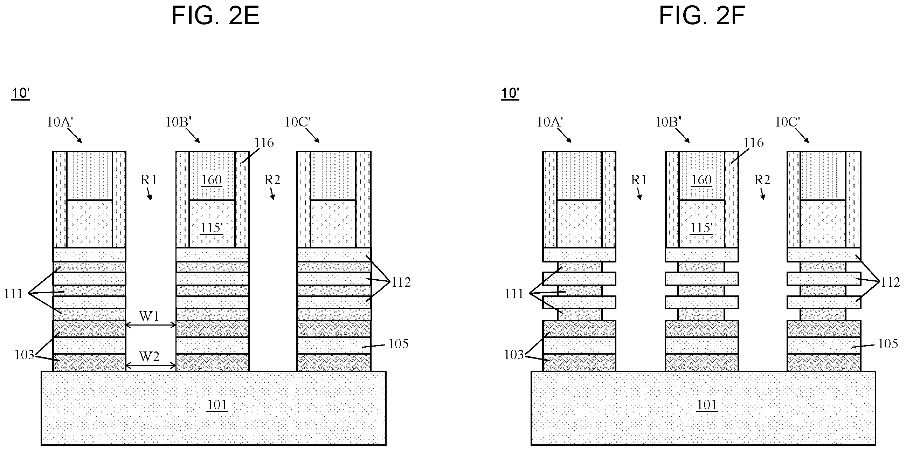

Referring to FIG. 2E, the preliminary isolation stack 100' may be etched down through the recesses R1 and R2 based on the hard mask patterns 160 and the gate spacers 116 to form three isolation stacks 100 on the substrate 101.

The preliminary isolation stack 100' may be etched to form three isolation stacks 100 and further extend the recesses R1 and R2 downward to provide a space for formation of a backside contact structure in a later step. Further, the three isolation stacks 100 patterned from the preliminary isolation stack 100' along with the three channel stacks 110 now form 1^{st} to 3^{rd} intermediate semiconductor stacks 10A'-10C'.

As described earlier in the Background section, the related art semiconductor devices may provide a backside contact structure which is filled in a hole or recess obtained by etching a substrate formed of silicon, and thus, the hole or recess may have a tapering or cone shape which may disrupt formation (deposition) of a metal therein.

However, as described earlier in reference to FIGS. 1A and 1B, the isolation layers 103 of the isolation stack 100 may be formed of silicon oxide (e.g., SiO₂), which has a higher etch rate than silicon. Thus, when the preliminary isolation stack 100' including the isolation layers 103 is etched to form a hole or recess in which a backside contact structure is to be formed, the hole or recess may have, for example, a substantially cylinder shape to better facilitate deposition of a metal therein to form a backside contact structure. Therefore, a lower portion of the extended recesses R1 and R2 formed by etching the preliminary isolation stack 100' may provide a constant width along the vertical direction. For example, a top width W1 of the lower portion of the recess R1 measured between the uppermost isolation layers 103 and a bottom width W2 of the lower portion of the recess R1 measured between the lowermost isolation layers 103 may be equal to each other.

Referring to FIG. 2F, side portions of each of the 2^{nd} sacrificial layers 111 in each of the intermediate semiconductor stacks 10A'-10C' may be dented or etched to provide spaces for forming the inner spacers 131 therein in a next step.

The etching operation in this step may be performed through, for example, selective wet etching or dry etching, not being limited thereto, remove only silicon germanium included in the 2^{nd} sacrificial layers 111 against silicon included in the channel layers 112, the substrate layer 105 and silicon oxide included in the isolation layers 103. For example, a mixture of hydrofluoric acid (HF) and nitric acid (HNO₃) may be used for the selective etching.

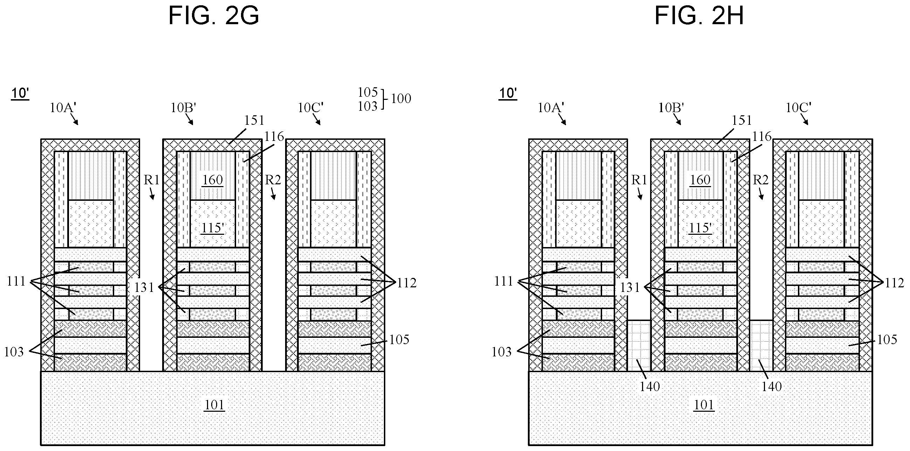

Referring to FIG. 2G, the inner spacers 131 may be formed at side surfaces of the dented 2^{nd} sacrificial layers 111, and the backside spacer 151 may be formed on the intermediate semiconductor device 10' obtained in the previous step to surround each of the intermediate semiconductor stacks 10A'-10C' on the substrate 101.

Each of the inner spacer 131 may be formed such that an outer side surface opposite to an inner side surface contacting the dented 2^{nd} sacrificial layer 111 is vertically aligned with or coplanar with the side surfaces of the channel layers 112 and the isolation stack 100. The backside spacer 151 may be conformally formed on an outer surface of each of the intermediate semiconductor stacks 10A'-10C' including the side surfaces of each of the isolation stacks 100. The formation of the inner spacers 131 and the backside spacers 151 may be performed through, for example, atomic layer deposition (ALD) or any other suitable deposition process or electroplating.

Although not shown in the drawings, the material such as silicon nitride (e.g., SiN, SiBCN, SiOCN, SiOC, etc.) forming the backside spacer 151 may be deposited on the entire intermediate semiconductor device 10' obtained in the previous step, and etched back to divide the backside spacer 151 into three backside spacers respectively surrounding the intermediate semiconductor stacks 10A'-10C'.

The formation of the backside spacers 151 in this manner may expose the top surface of the substrate 101 through the recesses R1 and R2. Further, a backside spacer 151 formed on a right side surface of the 1^{st} intermediate semiconductor stack 10A' may face a backside spacer 151 formed on a left side surface of the 2^{nd} intermediate semiconductor stack 10B' with the recess R1 therebetween, and a backside spacer 151 formed on a right side surface of the 2^{nd} intermediate semiconductor stack 10B' may face a backside spacer 151 formed on a left side surface of the 3^{rd} intermediate semiconductor stack 10C' with the recess R2 therebetween.

Referring to FIG. 2H, the placeholder structure 140 may be formed in the lower portion of each of the recesses R1 and R2 between the backside spacers 151 formed at the side surfaces of the isolation stacks 100.

The placeholder structure 140 may be formed to have the same thickness as the isolation stack 100 in the D3 direction. The placeholder structure 140 may include a material such as silicon germanium (SiGe) or silicon oxide (e.g., SiO, SiO₂, etc.), not being limited thereto. The formation of the placeholder structure 140 in the lower portion of each of the recesses R1 and R2 may be performed through, for example, CVD, PVD, PECVD, ALD, or a combination thereof, not being limited thereto.

Although not shown in the drawings, the material such as silicon germanium or silicon oxide forming the placeholder structure 140 may be deposited on the entire intermediate semiconductor device 10' obtained in the previous step to fill out the recesses R1 and R2, and etched back such that the top surface of the placeholder structure 140 may be horizontally aligned with or coplanar with a bottom surface of the lowermost 2^{nd} sacrificial layer 111 and the top surface of the uppermost isolation layer 103.

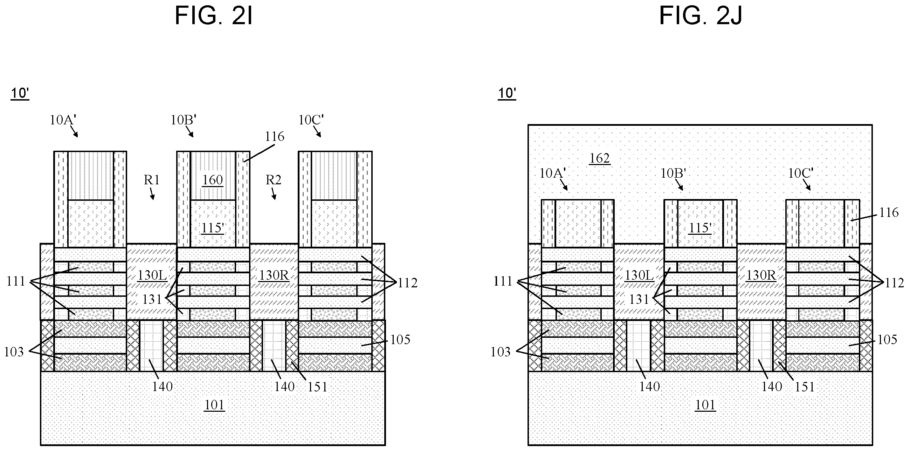

Referring to FIG. 2I, the backside spacers 151 may be etched back, and the source/drain regions including the 1^{st} and 2^{nd} source/drain regions 130L and 130R may be formed based on the channel layers 112.

The backside spacers 151 may be etched back such that a thickness of each of the backside spacers 151 may be the same as that of the placeholder structure 140 and the isolation stack 100.

The etch back of the backside spacer 151 may be performed through, for example, dry etching, not being limited thereto, such that the top surfaces thereof are horizontally aligned or coplanar with the top surfaces of the placeholder structures 140.

The source/drain regions including the 1^{st} and 2^{nd} source/drain regions 130L and 130R may be epitaxially grown from the channel layers 112 on or above the top surfaces of the placeholder structures 140 and the backside spacers 151.

Referring to FIG. 2J, the hard mask patterns 160 may be removed from each of the intermediate semiconductor stacks 10A'-10C', and the frontside isolation structure 162 may be formed at a front side of the intermediate semiconductor device 10' to surround the intermediate semiconductor stacks 10A'-10C'.

The removal of the hard mask patterns 160 may be performed through, for example, plasma ashing, stripping, etc. Further, the gate spacer 116 may be etched back so that a top surface thereof may be horizontally aligned or coplanar with a top surface of the dummy gate structure 115' in each of the intermediate semiconductor stacks 10A'-10C'.

The frontside isolation structure 162 may be formed through, for example, CVD, PVD, PECVD, ALD, or a combination thereof, not being limited thereto, and planarized through, for example, a CMP operation.

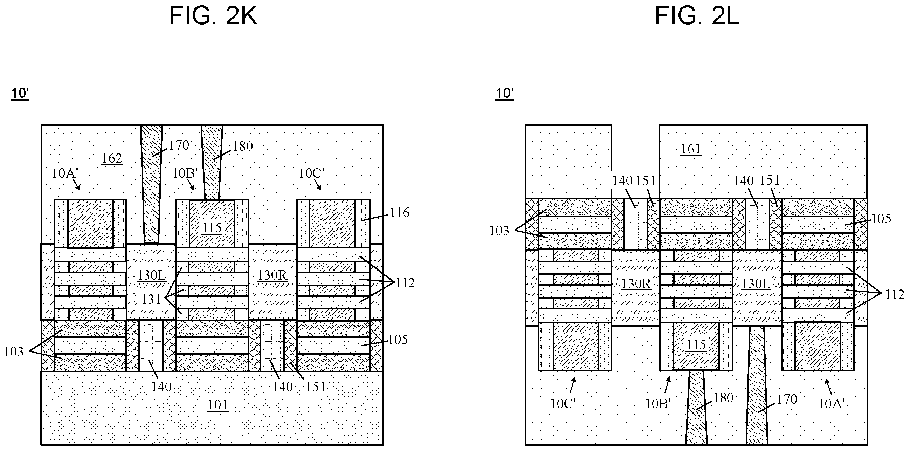

Referring to FIG. 2K, the dummy gate structure 115' and the 2^{nd} sacrificial layers 111 may be replaced by the gate structure 115, and the frontside contact structure 170 and the gate contact structure 180 may be formed to contact the 1^{st} source/drain region 130L and the gate structure 115, respectively.

The dummy gate structure 115' and the 2^{nd} sacrificial layers 111 may be removed through, for example, wet etching and/or dry etching, to leave voids or spaces in each of the intermediate semiconductor stacks 10A'-10C', and the gate structure 115 may be formed in those voids or spaces through, for example, CVD, PVD, PECVD, ALD, or a combination thereof, not being limited thereto.

The formation of the frontside contact structure 170 and the gate contact structure 180 may be performed through a similar deposition process after photolithography/masking/etching operations on the frontside isolation structure 162.

Referring to FIG. 2L, the intermediate semiconductor device 10' obtained in the previous step may be flipped upside down, and the substrate 101 may be removed and replaced by the backside isolation structure 161, which is patterned to expose the placeholder structure 140 and the backside spacers 151 formed below the 2^{nd} source/drain region 130R.

Although not shown in the drawings, a carrier substrate may be formed on a top surface of the intermediate semiconductor device 10' obtained in the previous step before the intermediate semiconductor device 10' is flipped upside down for a backside process.

The substrate 101 may be removed through, for example, dry etching, wet etching, ashing and/or stripping, and the backside isolation structure 161 may be formed through, for example, PVD, CVD, PECVD, etc. not being limited thereto, followed by planarization.

Further, the backside isolation structure 161 may be patterned through, for example, photolithography/masking/etching to expose the bottom surfaces of the placeholder structure 140 and the backside spacer 151 on which a subsequent backside process is to be performed in a next step. It is to be understood here that in FIG. 2J, the bottom surfaces of the placeholder structure 140 and the backside spacer 151 are shown as top surfaces thereof because the intermediate semiconductor device 10' has been inverted for a backside process.

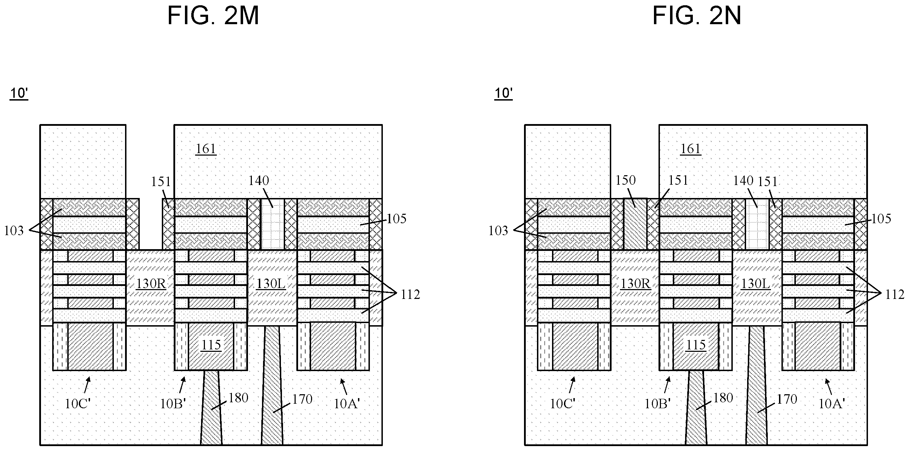

Referring to FIG. 2M, the placeholder structure 140 formed on the bottom surface of the 2^{nd} source/drain region 130R between the backside spacers 151 may be removed through selective etching against the backside spacers 151 based on the photoresist pattern.

The selective etching of the placeholder structure 140 including, for example, silicon germanium or silicon oxide against the backside spacers 151 including, for example, silicon nitride may be wet etching and/or dry etching using an etchant such as hot phosphoric acid (H3PO4) or potassium hydroxide (KOH), not being limited thereto.

Referring to FIG. 2N, the backside contact structure 150 may be formed in a void or space, from which the placeholder structure 140 has been removed in the previous step, in a self-aligning manner based on the backside spacers 151.

As discussed earlier, a metal such as copper (Cu), aluminum (Al), tungsten (W), ruthenium (Ru), molybdenum (Mo), etc. may be deposited in the void or space through, for example, CVD, PVD, PECVD or a combination thereof, not being limited thereto. Due to the backside spacers 151 formed at both sides of the void or space left from the removal of the placeholder structure 140, the metal deposited in the void or space may be self-aligned with the bottom surface (top surface in FIG. 2M) of the 2^{nd} source/drain region 130R.

As the backside contact structure 150 is formed by filling in the void or space left by the removal of the placeholder structure 140, the backside contact structure 150 may have the same shape as the placeholder structure 140. For example, a thickness of the backside contact structure 150 may be the same as that of the placeholder structure 140 in the D3 direction.

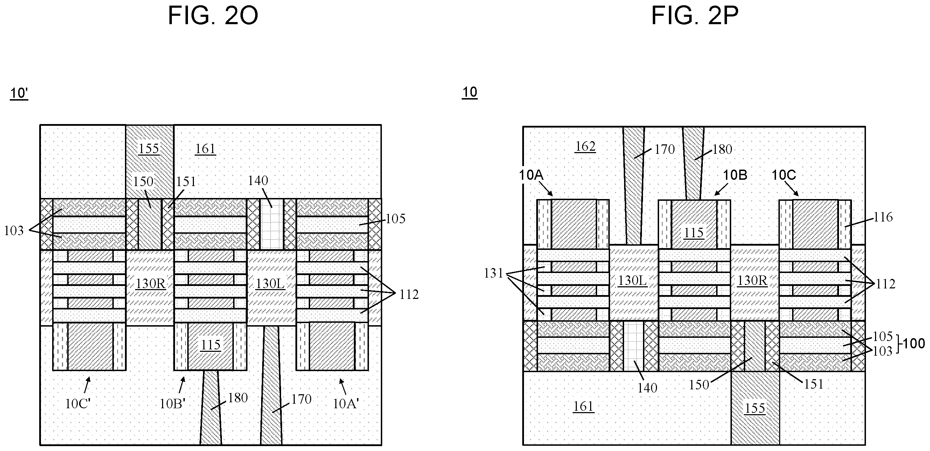

Referring to FIG. 2O, the backside metal line 155 may be formed to be connected to the backside contact structure 150 to finish a BSPDN of the intermediate semiconductor device 10'

A metal similar to that forming the backside contact structure 150 may be deposited through, for example, CVD, PVD, PECVD or a combination thereof, to form the backside metal line 155 which connects the 2^{nd} source/drain region 130R to a voltage source or another circuit element for internal routing purposes.

Referring to FIG. 2P, the intermediate semiconductor device 10' obtained in the previous step may be flipped upside down again to finish the manufacturing operation for the semiconductor device 10 at least in part.

The above embodiments have been described for manufacturing a semiconductor device including a plurality of nanosheet field-effect nanosheet transistors. However, the disclosure may not be limited thereto but may also apply to a semiconductor device including different types of field-effect transistor such as a FinFET.

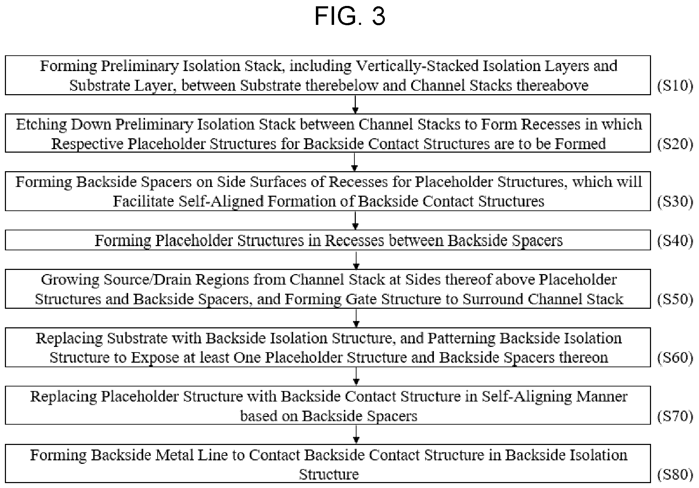

FIG. 3 illustrates a flowchart describing a method of manufacturing a semiconductor device including a self-aligned contact structure in reference to FIGS. 2A-2P, according to embodiments.

In step S 10, a preliminary isolation stack including two or more vertically-stacked isolation layers and a substrate layer therebetween may be formed between a substrate therebelow and a plurality of channel stacks thereabove, to form an intermediate semiconductor device. See FIGS. 2A-2C.

The isolation layers may be formed of a material including silicon oxide, which may more etching prone than silicon. A number of the isolation layers and a vertical thickness of the isolation stack may be controlled to correspond to or be the same as a vertical thickness of a backside contact structure to be formed in a later step.

In step S20, the preliminary isolation stack may be etched down between the channel stacks to form a plurality of isolation stacks, respectively below the channel stacks, and recesses in which respective placeholder structures for backside contact structures are to be formed. See FIGS. 2D-2F.

As the preliminary isolation stack includes the isolation layers formed of silicon oxide which is etching prone, it may be possible to etch out a hole or recess having a profile for easy deposition of a metal for a backside contact structure.

In step S30, backside spacers may be formed on side surfaces of the recesses for the placeholder structures, which will facilitate self-aligned formation of backside contact structures in a later step. See FIG. 2G.

The backside spacer may be formed to contact side surfaces of each of the isolation stacks. The backside spacer may be formed of a material such as silicon nitride.

In step S40, the placeholder structures may be formed in the recesses between the backside spacers. See FIG. 2H.

The placeholder structure may be formed of a material such as silicon germanium or silicon oxide.

In step S50, source/drain regions may be formed from the channel stacks at sides of the channel stacks on or above the placeholder structures and the backside spacers, and a gate structure may be formed to surround the channel stack. See FIGS. 2I-2K.

The source/drain regions may be formed such that the placeholder structures contact bottom surfaces of the source/drain regions, respectively, and the gate structure may be formed by replacing a dummy gate structure included in each of the channel stacks.

In step S60, the substrate may be removed and replaced by a backside isolation structure, and the backside isolation structure may be patterned to expose at least one of the placeholder structure and the backside spacers thereon. See FIG. 2L.

The removal of the substrate and the formation of the backside isolation structure may be performed after inverting the intermediate semiconductor device obtained in the previous step such that a bottom surface of the substrate is directed upward in the D3 direction.

The placeholder structure including silicon germanium or silicon oxide may be selectively etched against the backside spacers including silicon nitride.

In step S70, the placeholder structure may be removed and replaced by the backside contact structure in a self-aligning manner based on the backside spacers. See FIGS. 2M-2N.

Due to the backside spacers, the backside contact structure may be precisely aligned with the bottom surface of the source/drain region.

In step S80, a backside metal line may be formed to contact the backside contact structure in the backside isolation structure to at least partially finish a BSPDN of a semiconductor device. See FIGS. 2O-2P.

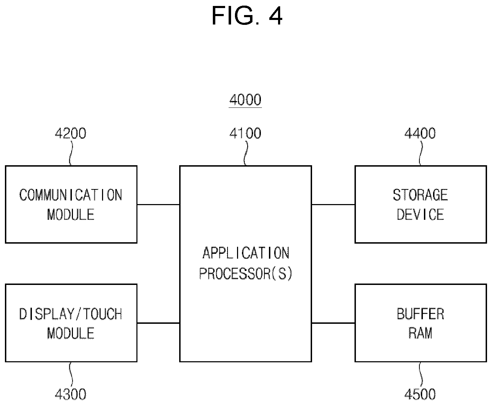

FIG. 4 is a schematic block diagram illustrating an electronic device including one or more semiconductor devices including a self-aligned backside contact structure as shown in FIGS. 1A and 1B, according to embodiments.

Referring to FIG. 4, an electronic device 4000 may include at least one application processor 4100, a communication module 4200, a display/touch module 4300, a storage device 4400, and a buffer RAM 4500. The electronic device 4000 may be a mobile device such as a smartphone or a tablet computer, not being limited thereto, according to embodiments.

The application processor 4100 may control operations of the electronic device 4000. The communication module 4200 is implemented to perform wireless or wire communications with an external device. The display/touch module 4300 is implemented to display data processed by the application processor 4100 and/or to receive data through a touch panel. The storage device 4400 is implemented to store user data. The storage device 4400 may be an embedded multimedia card (eMMC), a solid state drive (SSD), a universal flash storage (UFS) device, etc. The storage device 4400 may perform caching of the mapping data and the user data as described above.

The buffer RAM 4500 may temporarily store data used for processing operations of the electronic device 4000. For example, the buffer RAM 4500 may be volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

At least one component in the electronic device 4000 may include one or more semiconductor devices including a self-aligned backside contact structure as shown in FIGS. 1A and 1B.

## Claims

1. A semiconductor device (10) comprising:
a 1^{st} source/drain region (130L);
a 2^{nd} source/drain region (130R);
a channel structure (110) connecting the 1^{st} source/drain region (130L) to the 2^{nd} source/drain region (130R);
a gate structure (115) surrounding the channel structure (110);
a backside contact structure (150), below the 1^{st} source/drain region (130L), connected to the 1^{st} source/drain region (130L); and
the semiconductor device (10) **characterized by**
a 1^{st} backside spacer (151) at a lateral side of the backside contact structure (150), and/or
an isolation stack (100), below the gate structure (115), comprising at least one isolation layer (103) and a substrate layer (105) which are vertically stacked.

2. The semiconductor device (10) of claim 1, further comrpising:
a backside isolation structure (161) below the isolation stack (100).

3. The semiconductor device (10) of claim 1 or 2, wherein the at least one isolation layer (103) comprises a plurality of vertcially stacked isolation layers (103), and the substrate layer (105) is disposed between two adjacent isolation layers (103) among the isolation layers (103).

4. The semiconductor device (10) of any one of claims 1 to 3, further comprising:
a placeholder structure (140), below the 2^{nd} source/drain region (130R), connected to the 2^{nd} source/drain region (130R).

5. The semiconductor device (10) of claim 4, further comprising:
a 2^{nd} backside spacer (151) at a lateral side of the placeholder structure (140).

6. The semiconductor device (10) of of any one of claims 1 to 5, further comprising a frontside contact structure (170) on the 2^{nd} source/drain region (130R).

7. The semiconductor device (10) of any one of claims 1 to 6, further comprising:
a backside metal line (155), below the backside contact structure (150), connected to the backside contact structure (150).

8. The semiconductor device (10) of any one of claims 1 to 7, wherein the backside contact structure (150) and the 1^{st} backside spacer have a same vertical thickness.

9. The semiconductor device (10) of any one of claims 1 to 8,
wherein the isolation stack (100) and the backside contact structure (150) have a same vertical thickness.

10. The semiconductor device (10) of any one of claims 1 to 9, further comprising:
a substrate (101) below the isolation stack (100),
wherein one of the isolation layers (103) of the isolation stack (100) is disposed between the substrate (101) and the substrate layer (105), and
wherein the substrate (101) and the substrate layer (105) have a same material composition.

11. A method of manufacturing a semiconductor device (10), the method comprising following operations:
formig an isolation stack (100) comprising a plurality of isolation layers (103) and a substrate layer (105), between a substrate (101) and a channel stack (110);
etching the isolation stack (100) to form a recess (R1, R2);
forming a backside spacer (151) at a side surface of the recess (R1, R2);
forming a placeholder structure (140) in the recess (R1, R2) based on the backside spacer (151);
forming a source/drain region (130L, 130R) on the placeholder structure (140) based on the channel stack (110); and
replacing the placeholder structure (140) with a backside contact structure (150) based on the backside spacer (151).

12. The method of claim 11, wherein the backside spacer (151) and the isolation stack (100) have a same vertical thickness.

13. The method of claim 11 or 12, wherein an isolation layer (103) among the isolation layers (103) is disposed between the substrate (101) and the substrate layer (105).

14. The method of any one of claims 11 to 13, wherein the placeholder structure (140), the backside contact structure (150) and the isolation stack (100) have a same vertical thickness.
